(19) Europäisches Patentamt / European Patent Office / Office européen des brevets

(11) **EP 4 155 741 B1**

(12) **EUROPEAN PATENT SPECIFICATION**

(45) Date of publication and mention
of the grant of the patent:
**13.08.2025   Bulletin 2025/33**

(51) International Patent Classification (IPC):
**G01R 31/30** *(2006.01)*          **G05F 1/46** *(2006.01)*
**G01R 31/26** *(2020.01)*

(21) Application number: **22192401.2**

(22) Date of filing: **26.08.2022**

(52) Cooperative Patent Classification (CPC):
**G05F 1/46; G01R 31/3004;** G01R 31/2642

(54) **CONTROL APPARATUS, DEVICE, METHOD AND COMPUTER PROGRAM FOR DETERMINING A DEVICE-SPECIFIC SUPPLY VOLTAGE FOR A SEMICONDUCTOR DEVICE**

STEUERVORRICHTUNG, VORRICHTUNG, VERFAHREN UND COMPUTERPROGRAMM ZUM ERMITTELN EINER GERÄTESPEZIFISCHEN VERSORGUNGSSPANNUNG FÜR EIN HALBLEITERBAUELEMENT

APPAREIL DE COMMANDE, DISPOSITIF, PROCÉDÉ ET PROGRAMME INFORMATIQUE POUR DÉTERMINER UNE TENSION D'ALIMENTATION SPÉCIFIQUE À UN DISPOSITIF POUR UN DISPOSITIF À SEMI-CONDUCTEUR

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **27.09.2021   US 202117448902**

(43) Date of publication of application:
**29.03.2023   Bulletin 2023/13**

(73) Proprietor: **INTEL Corporation**
**Santa Clara, CA 95054 (US)**

(72) Inventors:
• **RIFANI, Michael**
  **Beaverton, 97007 (US)**
• **IOVINO, Gregory**
  **Portland, 97229 (US)**
• **RECHTER, Roman**
  **Even Yehuda (IL)**
• **MCFARLAND, Grant**
  **Hillsboro, 97124 (US)**
• **KURD, Nasser A.**
  **Portland, 97229 (US)**
• **FETZER, Eric**
  **Loveland, 80537 (US)**
• **HENINGER, Kurt**
  **Hillsboro, 97124 (US)**
• **YU, Qinxin**
  **Pacifica, 94044 (US)**
• **RAMASWAMY, Preethi**
  **Freemont, 94539 (US)**
• **AHMED, Monib**
  **Portland, 97229 (US)**
• **GOITIA, Pauline**
  **Folsom, 95630 (US)**
• **LANKA, Narasimha**
  **Dublin, 94568 (US)**
• **RASHID, Mohammad**
  **San Jose, 95148 (US)**
• **WONG, Kit Seong**
  **San Jose, 95132 (US)**

(74) Representative: **2SPL Patentanwälte PartG mbB**
**Landaubogen 3**
**81373 München (DE)**

(56) References cited:
**US-A1- 2004 051 553      US-A1- 2006 223 201**
**US-A1- 2014 312 873      US-B1- 9 672 310**

## Description

### Field

Examples relate to control apparatus, a control device, a method, and a computer program for determining a device-specific supply voltage for a semiconductor device, and to a corresponding semiconductor device and corresponding systems.

### Background

The sale of a product, such as a semiconductor device, is often based on an agreement which guarantees a certain performance level throughout the lifetime of the product. In other words, the product is sold with the promise of a certain level of performance, which is usually guaranteed for a pre-defined length of time, i.e., the "lifetime of the product". However, performance in the field depends on a dynamic set of factors, not the least of which is aging due to the history of utilization unique to individual part. As such, it is difficult to account for all the factors affecting performance per part in the field and to predict their interactions ahead.

To overcome this difficulty, state-of-the-art high-volume manufacturing (HVM) use statistical data of an entire population of parts to predict performance per part. Learnings from past products, and constantly evolving performance benchmarks, are used to construct predictive models.

Aging effects on all components in a product noticeably degrade the overall performance of a server over its lifetime. Especially in a server farm, by virtue of the sheer number of parts involved, operational cost is a sensitive function of this performance degradation. Due to a constantly high activity factor, exacerbated by self-heat, a server is more vulnerable to aging compared to other platforms. The above-mentioned predictive performance model may take this degradation into account, by applying statistical guardbands on operational condition requirements.

US 9672310 B1 titled "Reliability guardband compensation" discusses a method to prevent incorrect operation in integrated circuits (IC) caused by aging effects. In this approach, an IC-specific age model is generated early in the product life cycle of the IC to determine the amount of supply voltage guardband needed. This age model is developed using high temperature operating life (HTOL) testing conducted at various temperatures and voltages. By continuously monitoring the aging effects during IC operation, the IC-specific age model is used to predict the appropriate amount of increased guardband voltage. This predicted amount can range from zero when the IC is new to the full guardband voltage when the IC is nearing its end of life.

US 2014312873 A1titled "ESTIMATING AND MONITORING THE EFFECTS OF TRANSISTOR AGING" discusses a method for monitoring the deterioration of a circuit. In one embodiment, the method involves activating an aging unit within the circuit at a certain time and, in response to a trigger event, activating a non-aging unit. The method then involves comparing the frequencies generated by the aging unit and the non-aging unit to identify any differences. Based on these differences, a modified power supply voltage is generated and applied to the non-aging unit.

### Summary

The invention is set out in the appended set of claims.

### Brief description of the Figures

Some examples of apparatuses and/or methods will be described in the following by way of example only, and with reference to the accompanying figures, in which

Fig. 1      shows a schematic diagram illustrating how a supply voltage is chosen in some approaches;

Fig. 2a     show a block diagram of an example of a control apparatus or control device for determining a device-specific supply voltage for a semiconductor device;

Fig. 2b     shows a flow chart of an example of a method for determining a device-specific supply voltage for a semiconductor device;

Fig. 2c     shows a block diagram of an example of a semiconductor device comprising a control apparatus or control device for determining a device-specific supply voltage for the semiconductor device;

Fig. 2d     shows a block diagram of an example of a system comprising a control apparatus or control device for determining a device-specific supply voltage for the semiconductor device and a supply voltage control apparatus or device;

Fig. 3    shows a schematic diagram of a supply voltage required for operating a semiconductor device across its lifetime;

Fig. 4    shows a schematic diagram illustrating a degradation of a minimal supply voltage required for a semiconductor device over time;

Fig. 5    shows a schematic diagram of a supply voltage required for operating a semiconductor device across its lifetime, with the lifetime being extended due to reduced supply voltage in the first years; and

Fig. 6    shows a schematic diagram of a graph defining a translation between In-Die Variation (IDV) frequency and supply voltage.

## Detailed Description

Some examples are now described in more detail with reference to the enclosed figures. However, other possible examples are not limited to the features of these examples described in detail. Other examples may include modifications of the features as well as equivalents and alternatives to the features. Furthermore, the terminology used herein to describe certain examples should not be restrictive of further possible examples.

Throughout the description of the figures same or similar reference numerals refer to same or similar elements and/or features, which may be identical or implemented in a modified form while providing the same or a similar function. The thickness of lines, layers and/or areas in the figures may also be exaggerated for clarification.

When two elements A and B are combined using an 'or', this is to be understood as disclosing all possible combinations, i.e. only A, only B as well as A and B, unless expressly defined otherwise in the individual case. As an alternative wording for the same combinations, "at least one of A and B" or "A and/or B" may be used. This applies equivalently to combinations of more than two elements.

If a singular form, such as "a", "an" and "the" is used and the use of only a single element is not defined as mandatory either explicitly or implicitly, further examples may also use several elements to implement the same function. If a function is described below as implemented using multiple elements, further examples may implement the same function using a single element or a single processing entity. It is further understood that the terms "include", "including", "comprise" and/or "comprising", when used, describe the presence of the specified features, integers, steps, operations, processes, elements, components and/or a group thereof, but do not exclude the presence or addition of one or more other features, integers, steps, operations, processes, elements, components and/or a group thereof.

In the following description, specific details are set forth, but embodiments of the technologies described herein may be practiced without these specific details. Well-known circuits, structures, and techniques have not been shown in detail to avoid obscuring an understanding of this description. "An embodiment/example," "various embodiments/example," "some embodiments/example," and the like may include features, structures, or characteristics, but not every embodiment necessarily includes the particular features, structures, or characteristics.

Some embodiments may have some, all, or none of the features described for other embodiments. "First," "second," "third," and the like describe a common element and indicate different instances of like elements being referred to. Such adjectives do not imply element item so described must be in a given sequence, either temporally or spatially, in ranking, or any other manner. "Connected" may indicate elements are in direct physical or electrical contact with each other and "coupled" may indicate elements co-operate or interact with each other, but they may or may not be in direct physical or electrical contact.

As used herein, the terms "operating", "executing", or "running" as they pertain to software or firmware in relation to a system, device, platform, or resource are used interchangeably and can refer to software or firmware stored in one or more computer-readable storage media accessible by the system, device, platform or resource, even though the instructions contained in the software or firmware are not actively being executed by the system, device, platform, or resource.

The description may use the phrases "in an embodiment/example," "in embodiments/example," "in some embodiments/examples," and/or "in various embodiments/examples," each of which may refer to one or more of the same or different embodiments or examples. Furthermore, the terms "comprising," "including," "having," and the like, as used with respect to embodiments of the present disclosure, are synonymous.

Various examples of the present disclosure relate to a concept for an adaptive supply voltage against aging per part in the field. The proposed concept may reduce or eliminate most factors of the statistical guardband associated with aging.

A member of a manufactured ensemble of a product is referred to as a *part*. HVM organizes parts of statistically similar performance characteristics into a group, or *bin*. Each bin is associated with a market segment and price commensurate with the performance of its weakest part, to guarantee that all parts of the bin can uphold the service agreement associated with the bin. The members of a bin are usually sold as a stock keeping unit (SKU).

Statistical data from previous high-volume products is used in state-of-the-art HVM methodology to predict aging-related failures of the current product as a function of the power-supply voltage. However, per-part differences in actual aging variation are difficult to predict ahead. For each part, actual aging may be a nonlinear confluence of intrinsic aging variability, utilization level (e.g. activity factor of turbo), conditions (e.g. temperature during turbo) and voltage.

In other words, some statistical distributions modeling does take place, but can only be on the conservative side. As a part degrades due to aging, the minimum power supply voltage, denoted by $V_{min}$, required to sustain the guaranteed performance level must be increased to compensate for the diminishing performance. This amount of voltage increase is denoted by $V_{min}$ *guardband*. At shipping, $V_{min}$ guardband for an entire bin is based on the statistical model as it pertains to the weakest member of the bin.

Some semiconductor devices use In-Die Variation (IDV) oscillators to measure various characteristics of each part, including aging effects. But IDV measurements have been confined to manufacturing contexts and have not been used in the field as the basis for an adaptive configuration. $V_{min}$ guardband based on high-volume burn-in acceleration experiments must also account for reasonable differences between the predictive model vs. real-life aging.

Also, some HVM approaches employ design and manufacturing techniques to address performance degradation of products due to aging. They combine robustness in architecture and circuit design, and distribute the utilization, and thus the burden due to aging effects across the part. Circuits most vulnerable to non-idealities become a limiter in the performance of the product. Commonly referred to as *speed-paths,* these circuits must be predicted during product design based on theoretical simulations. Once identified, they are routinely over-designed.

A fixed $V_{min}$ guardband at shipping for all parts in a bin may translate to a down-binning of parts or, worse yet, yield loss; all of which lead to a reduction in revenue, as some parts may be sorted into a lower bin, and some parts may be excluded from any useable bin.

Some concepts address aging-related failures during manufacturing based on theoretical models and past data. They try to predict degradation and ultimately failure mechanisms despite a wide variety of utilizations in real-world applications. They fix the power supply voltage at shipping based on the weakest member of the bin, which may be an overkill for most of the lifespan for most members of the bin. Without per-part, in-the-field adaptation, many HVM practices may decide on a fixed $V_{min}$ value high enough to sustain the agreed-upon minimum performance level for the weakest part of the bin. The fixed $V_{min}$ may be enforced in all parts of that bin throughout the lifespan of their service. But near the beginning of life, that same $V_{min}$ value is more than enough to sustain the guaranteed minimum performance level for most of the parts in the bin. In other words, some parts consume more power than necessary. Moreover, a heightened voltage level may accelerate the aging process.

Studies show that the manufacturing of server components often leads to lower yields due to delayed scaling of the yield, low utilization and/or density, and the inability to productize partially defective parts. Studies also show advantages of aging compensation techniques, such as a 2%-10% improvement of clock circuitry by compensating against aging.

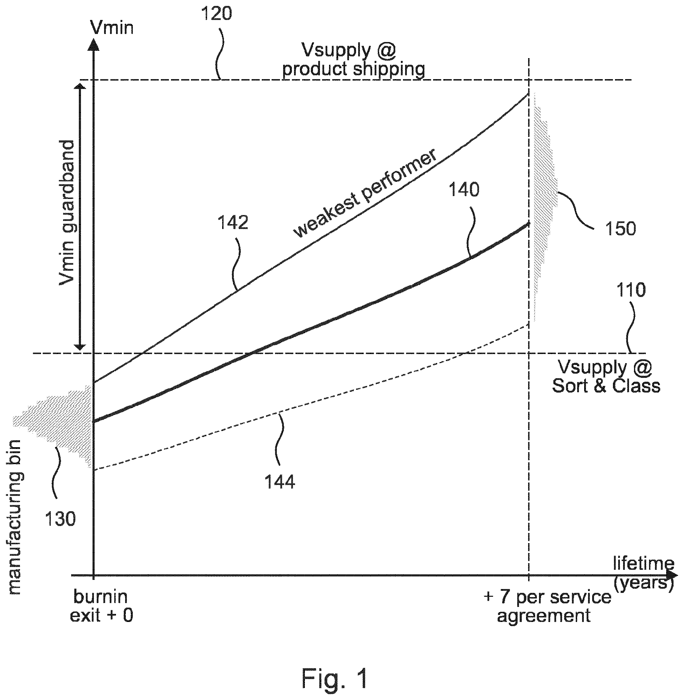

Fig. 1 illustrates how the fixed $V_{min}$ (Product shipping $V_{supply}$) is chosen in some approaches. Fig. 1 shows a schematic diagram illustrating how a supply voltage is chosen in some approaches. The x-axis of Fig. 1 shows the timeline, starting from burn-in and manufacturing exit of the semiconductor devices to +7 years, which is a common lifetime being defined for semiconductor devices being used in server environments. The y-axis shows $V_{min}$. Left of the x-axis. Two supply volage lines are shown in Fig. 1 - a first line 110 denoting $V_{supply}$ at Sort & Class, i.e., the supply voltage that has been used when the parts were sorted into the bin, and a second line 120 denoting $V_{supply}$ that was used at shipping time, which corresponds to a fixed $V_{min}$ guardband. The guardband is illustrated between lines 110 and 120.

Left of the x-axis, the distribution 130 of the parts of the bin is shown, with the distribution indicating the $V_{min}$ necessary to operate the respective part at the desired performance at the time of burn-in and manufacturing exit, i.e., before aging has deteriorated the performance. On the other end of the time-scale, at 7 years after manufacturing, another distribution 150 is shown, indicating the $V_{min}$ necessary to operate the respective part at the desired performance after seven years. As is evident, the distribution stretches over more voltage levels, as parts age differently, and in particular as the weakest and best performers of a bin age differently. Graphs 140, 142 and 144 indicate the voltages required by the median, weakest, and best parts of the respective bin.

A further aspect of some examples of the proposed concept is that it employs software to organize existing hardware to measure aging characteristics. The software may analyze the measurement and adapt the operation of the part accordingly. Most importantly, the software layer may enable many degrees of freedom and algorithmic sophistication not practical or altogether available in some approaches. For example, existing hardware may be used to implement the proposed concept. Various features of the proposed concept are implemented in software and distinguish themselves via their new command of the hardware.

The measurements and adaptations being performed on a per part basis in the field without interrupting functional operation, hereby characterized as *in vivo,* may be considered to be another key aspect of the proposed concept. Various examples of the present disclosure may thus combine software and hardware innovations to implement an adaptive countermeasure against aging effects on a per part basis in the field.

The proposed concept may yield to improvements in yield and binning criteria of success, which may reduce the inefficiencies and loss of revenue due to $V_{min}$ guardband. The proposed concept also enables adaptive behavior in vivo throughout the lifetime of the product, which may simplify some of the design constrains of the speed-paths, which may be beneficial to the manufacturer of the part across the entirety of each part, and throughout the lifetime of the part. For the customers using the respective parts, the proposed concept may reduce the average value of power consumption over the lifespan of the product compared to other concepts.

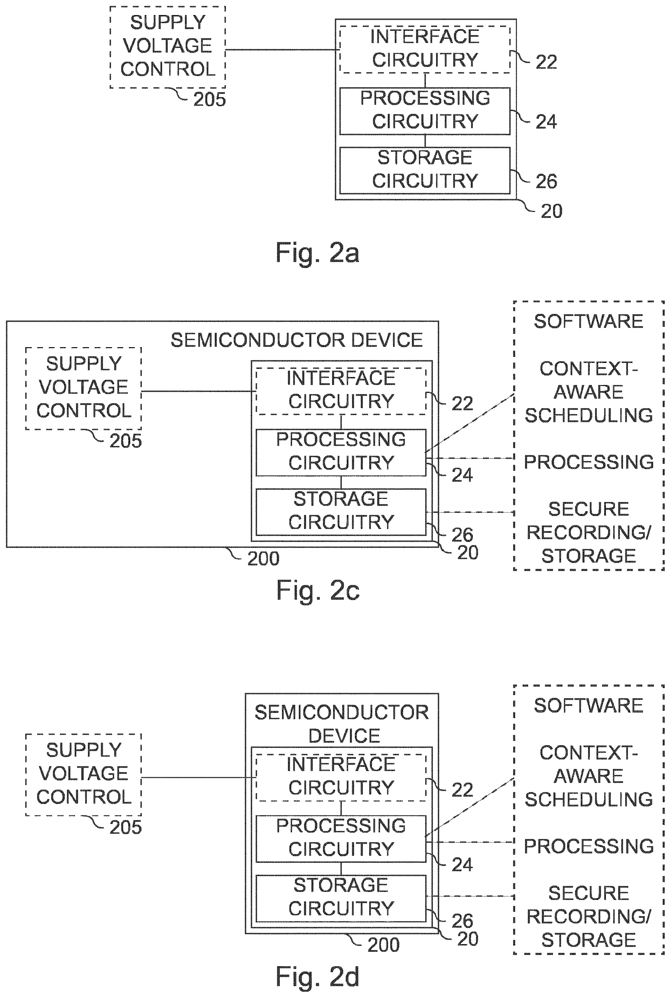

Fig. 2a show a block diagram of an example of a control apparatus 20 or control device 20 for determining a device-specific supply voltage for a semiconductor device 200 (shown in Fig. 2c). The control apparatus comprises circuitry that is configured to provide the functionality of the control apparatus. Correspondingly, the control device comprises means for providing the functionality of the control device. The components of the control device are defined as component means, which may be implemented using the corresponding structural components of the control apparatus.

For example, the control apparatus 20 comprises processing circuitry 24 and storage circuitry 26. Optionally, the control apparatus 20 further comprises interface circuitry 22. The processing circuitry 24 is coupled with the storage circuitry and the optional interface circuitry 22. In general, the functionality of the control apparatus 20 is provided by the processing circuitry 24, in conjunction with the storage circuitry 26 (for storing and retrieving information) and the interface circuitry (for exchanging information) 22. The control device 20 comprises means for processing 24, which may be implemented by the processing circuitry 24, means for storing information 26, which may be implemented by the storage circuitry 26, and, optionally, means for communicating 22, which may be implemented by the interface circuitry 22. In general, the functionality of the control device 20 is provided by the means for processing 24, in conjunction with the means for storing information 26 (for storing and retrieving information) and the means for communicating 22 (for exchanging information).

The control apparatus or device 20 is configured to obtain measurement data of measurement circuitry of the semiconductor device (e.g., via the interface circuitry / means for communicating 22). The measurement data is related to a progress of aging of the semiconductor device. The control apparatus or device 20 is configured to determine the device-specific supply voltage of the semiconductor device based on the measurement data. The control apparatus or device 20 is configured to provide information on the device-specific supply voltage for a supply voltage control apparatus 205 (e.g., via the interface circuitry / means for communicating 22). For example, the control apparatus or device 20 may be configured to store the measurement data using the storage circuitry / means for storing information 26.

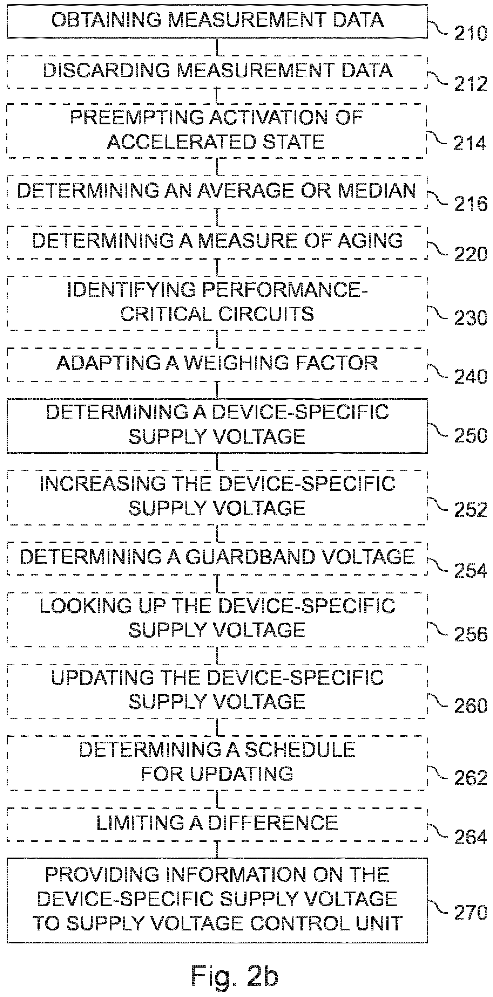

Fig. 2b shows a flow chart of an example of a corresponding method for determining a device-specific supply voltage for the semiconductor device. The method comprises obtaining 210 the measurement data of the measurement circuitry of the semiconductor device, the measurement data being related to a progress of aging of the semiconductor device. The method comprises determining 250 the device-specific supply voltage of the semiconductor device based on the measurement data. The method comprises providing 270 information on the device-specific supply voltage for a supply voltage control apparatus 205.

In the following, the functionality of the control apparatus or device 20 and the feature of the corresponding method and/or a corresponding computer program are described with respect to the control apparatus 20. Features introduced in connection with the control apparatus 20 may be likewise included in the corresponding control device 20, method and computer program.

Various examples of the present disclosure relate to a control apparatus 20, a control device 20, a method and a computer program for determining a device-specific supply voltage for a semiconductor device 200. As outlined above, examples of the proposed concept deviate from the concept of setting a supply voltage that is designed to guarantee the performance of the semiconductor device over a pre-defined lifetime of the semiconductor device, by periodically re-evaluating, on a per-part basis, in the field, the supply voltage required by the semiconductor device to provide the desired performance. Therefore, the device-specific supply voltage is adapted, over time, to the supply voltage required at that point in time to operate the semiconductor device at the desired performance. As has become evident with respect to Fig. 1, the supply voltage required for operating the semiconductor device at the desired performance generally increases over time. For example, electromigration and other effects may lead to a deterioration of the performance of the individual gates and circuits of the semiconductor device. As a consequence, signals transitioning from a "low" state to a "high" state may require more time for the transition, which generally has adverse effects on the timing between gates and circuits of the semiconductor device. By increasing the supply voltage, the time required for the signal transition can be decreased, thereby countering the effects of aging. Therefore, the control apparatus may be configured to increase the device-specific supply voltage as the aging of the semiconductor device progresses. Accordingly, the method may comprise increasing 252 the device-specific supply voltage as the aging of the semiconductor device progresses. However, in general, by using a higher supply voltage, an energy consumption of the semiconductor device is increased, and more cooling is required.

Various examples of the present disclosure are thus based on the insight, that the supply voltage of the semiconductor device is to be increased moderately, on a per-device basis, to allow for the desired performance, while keeping the energy consumption lower than in other systems, where a constant, device-independent supply voltage is used. Therefore, the device-specific supply voltage is gradually adapted based on the progress of aging of the semiconductor device, to counteract the effects of the aging of the (specific) semiconductor device. Consequently, the device-specific supply voltage is based on the progress of aging of the semiconductor device. Moreover, the adaptation is performed individually for each individual semiconductor device, e.g., without using a statistical model that is models the aging process of an entire bin or SKU of semiconductor devices. In other words, the progress of aging (being referred to in the present context) is based on an individual aging process of the semiconductor device in the field.

As has become evident, three components are involved in the present concept - a controller (e.g., the control apparatus or device, or a microcontroller performing the method or computer program), the supply-voltage control apparatus (or device) 205, and the semiconductor device 200. In some examples, the former two components are part of the semiconductor device. Such an example is shown in Fig. 2c. Fig. 2c shows a block diagram of an example of a semiconductor device 200 comprising the control apparatus or control device 20 for determining a device-specific supply voltage for the semiconductor device and the supply-voltage control apparatus (or device) 205. The supply-voltage control apparatus (or device) 205 is coupled with the control apparatus or device 20 (e.g., via the interface circuitry / means for communicating 22). The supply-voltage control apparatus (or device) 205 is configured to control the supply voltage being supplied to the semiconductor device. Fig. 2c shows a system comprising the control apparatus or device and the semiconductor device 200. For example, the system may further comprise the supply voltage control device apparatus 205.

In some other examples, the control apparatus or control device 20 and/or the supply-voltage control apparatus (or device) 205 may be separate from the semiconductor device 200. Such an example is shown in Fig. 2d. Fig. 2d shows a block diagram of an example of a system comprising the control apparatus or control device 20 and the supply voltage control apparatus or device 205.

Other examples provide hybrid approaches. For example, the semiconductor device may comprise the control apparatus or control device 20, while the supply voltage control apparatus or device 205 is separate from the semiconductor device 200 (e.g., a separate semiconductor device). Alternatively, the semiconductor device may comprise the supply voltage control apparatus or device 205, and the control apparatus or control device 20 may be separate from the semiconductor device 200 (e.g., a separate microcontroller).

The proposed concept is based on a long-time analysis of measurement data, with the analysis being performed over a time horizon that can span multiple years. As will become evident, the proposed concept is particularly suited for implementation in software that is being executed on a microcontroller (or a processor). For example, the software layer may have access to an architectural state and operational condition of the semiconductor device. Also, software may be cognizant of time on a scale long enough for aging to be an issue. For example, the analysis of large amounts of measurement data may be facilitated by implementation in software. Moreover, a software environment can be used to consider additional information regarding the context in which the measurement is performed, such as the time elapsed since burn-in, an activation of an accelerated state ("turbo state") of the semiconductor device, a runtime or activity factor of circuitry of the semiconductor device etc., which may be used to weigh different factors derived from the measurement data. Moreover, an average or median value may be determined over multiple samples to filter out noise or outliers. All of this is facilitated by an implementation in software. On top, the software can be updated if more precise mechanisms for determining the device-specific supply voltage are developed. As indicated by the block shown in dashed lines in Figs. 2c and 2d, the proposed concept is based on a software block that is qualified to make decisions on how to schedule IDV measurements (using context-aware scheduling), to analyze results from the measurements in the context that they are recorded (by processing the measurement data), and to adapt the operation of the semiconductor device based on the analysis. Furthermore, secure recording and/or storage of the measurement data and/or the determined device-specific supply voltage may be managed by the software block. Accordingly, the control apparatus may be implemented by software being executed on a microcontroller (or processor). Correspondingly, the method may be implemented by software being executed on a microcontroller (or processor). For example, a microcontroller of the semiconductor device (or the semiconductor device itself) may be used. For example, a power control unit (PCU) microcontroller of the semiconductor device may be used. In other words, the control apparatus may be implemented using a microcontroller of the semiconductor device, and the method may be performed using a microcontroller of the semiconductor device, e.g., by software being executed on a microcontroller of the semiconductor device. For example, the microcontroller may comprise or implement the processing circuitry / means for processing 24, the interface circuitry / means for communicating 22 and/or the storage circuitry / means for storing information 26.

The proposed concept is applicable to a wide range of semiconductor devices. It is particularly suitable for semiconductor devices that require fast signal transitions (e.g., due to a multi-GHz clock speed), such as Central Processing Units (CPUs), Graphics Processing Units (GPUs) and/or mobile communication processors/baseband processors, and/or semiconductor device that are optimized for low power consumptions (e.g., mobile CPUs, mobile GPUs, or mobile communication processors/baseband processors to be used in a battery-powered device. For example, the semiconductor device may be one of a central processing unit, a graphics processing unit, a computing accelerator, a network interface controller, a communication processor, a cellular communication processor, a baseband processor, a serialiser-deserialiser (SerDes), a transceiver, a receiver, and a transmitter.

The proposed concept is based on the analysis of measurement data, which is generated by measurement circuitry of the semiconductor device. In other words, the supply voltage of the semiconductor device is determined, and subsequently adapted, based on measurements being generated on-device, in the field, while the semiconductor device is in use by the customer. Consequently, the device-specific supply voltage is specific to the semiconductor device comprising the measurement circuitry.

In the proposed concept, so-called In-Die-Variation (also Intra-Die-Variation, IDV) circuitry is used to perform the measurements on the semiconductor device. The IDV circuitry is part of the semiconductor device and is generally used during manufacturing, e.g., to identify defunct semiconductor devices and for binning. In the proposed concept, the IDV circuitry is re-purposed for determining the effects of aging on the semiconductor device. For example, the aging effect may be measured by sampling a counter output from IDV. Properly scheduled, successive samplings may reveal a progressively worsening delay of the IDV, due to structural aging.

The control apparatus is configured to obtain the measurement data of the measurement circuitry of the semiconductor device, with the measurement data being related to a progress of aging of the semiconductor device. In this context, the measurement data being related to a progress of aging of the semiconductor device means that the measurement data changes over time as the semiconductor device ages. The more the semiconductor device is used, the more pronounced the effects due to aging usually are, e.g., due to the electromigration or similar effects occurring during usage of the semiconductor device. Therefore, the progress of aging of the semiconductor device may be based on a utilization of the semiconductor device, with the measurement data reflecting the utilization of the semiconductor device. For example, the measurement data may be based on the time required for transitioning a signal from a "low" state to a "high" state, or the measurement data may be based on an error count of errors caught via a redundancy check, both of which increase with time.

As outlined above, the time required for a signal transitioning from "low" to "high" is a major factor that is dependent on the progress of aging of the device. An effective approach for determining the progress of aging of a semiconductor device is to (indirectly) measure this transition time. This can be done by creating a circle (or ring) of gates/transistors that are wired to propagate a signal transition around the circle / ring, thereby creating an oscillation. The faster the signal transition, the higher the oscillation frequency of the ring oscillator. This oscillation frequency may be proportional to the transition time, and thus reflect the progress of aging of the semiconductor device. Accordingly, the measurement data may comprise measurement data related to one or more ring oscillator circuit arrangements of the semiconductor device. In other words, the measurement circuitry may comprise one or more ring oscillator circuit arrangements. As outlined above, the measurement data related to the one or more ring oscillator circuit arrangements may represent an (oscillation) frequency of the one or more ring oscillator circuit arrangements of the semiconductor device. In some examples, the ring oscillator circuit arrangements are used in pairs, with one of the pairs being in operation while the semiconductor device is operation while the semiconductor device is in operation, and the other being deactivated when not used to generate samples of measurement data. Thus, the frequency of at least one of the one or more ring oscillator circuit arrangements (i.e., the one being in operation while the semiconductor device is in operation) is dependent on the progress of aging of the semiconductor device.

Expanding on the use of ring oscillator circuit arrangements in pairs, the measurement data related to one or more ring oscillator circuit arrangements may correspond to measurement data related to one or more pairs of ring oscillator circuit arrangements. Each pair of ring oscillator circuit arrangements may comprise a first ring oscillator circuit arrangement having a performance being dependent on the progress of aging of the semiconductor device, and a second oscillator circuitry being at least partially safeguarded from the progress of aging of the semiconductor device. In general, the first ring oscillator circuit arrangement may be activated in-line with the operation of the semiconductor device, such that the first ring oscillator circuit arrangement ages in line with the semiconductor device (or at least with a portion of the semiconductor device being characterized by the particular first ring oscillator circuit arrangement). The second ring oscillator circuit arrangement, in contrast, is at least partially safeguarded from the progress of aging of the semiconductor device. For example, the second ring oscillator circuit arrangement may be deactivated in general, and only activated for the purpose of generating the measurement data. In other words, the second ring oscillator circuit arrangement may lie dormant outside the generation of measurement data. In some cases, the second ring oscillator circuit arrangement is also called a reference ring oscillator circuit arrangement.

In general, a semiconductor device comprises circuitry being configured to provide the functionality of the semiconductor device. The proposed concept is particularly applicable to highly complex semiconductor device comprising highly complex circuitry. For example, modern CPUs, FPGAs, or GPUs comprise many billions of transistors, which are used to provide a multitude of functionality. However, the circuitry of a semiconductor device often is not used in a uniform manner. Clock-gating may be used to deactivate circuitry that is momentarily not in used (e.g., to conserve energy), and some portions of circuitry are simply used more often than others. Moreover, some portions of the circuitry carry higher currents, and are therefore more susceptible to the effects associated with aging. Finally, circuitry often includes one or more critical paths (also called speed paths) that are particularly sensitive to degradation of performance (as delays on the critical paths/speed paths can interfere e.g., with setup/hold timing of registers). Consequently, to determine the effects of aging on the semiconductor device, multiple measurements may be taken, to gain a comprehensive representation of the progress of aging of the semiconductor device. Accordingly, the measurement data related to the one or more ring oscillator circuit arrangements may correspond to measurement data related to a plurality of (pairs of) ring oscillator circuit arrangements being arranged at a plurality of different portions of the semiconductor device. For example, the plurality of (pairs of) ring oscillator circuit arrangements may be arranged in proximity of the speed paths/critical paths of the semiconductor device. In other words, the plurality of (pairs of) ring oscillator circuit arrangements may be arranged in proximity of components of the circuitry being characterized by the respective (pair of) ring oscillator circuit arrangement.

In general, the measurement circuitry is configured to generate the measurement data. In the case of the ring oscillator circuit arrangement(s), the semiconductor device may comprise counter circuitry for determining the frequency of the ring oscillator circuit arrangement(s). In general, the frequency of the ring oscillator circuit arrangement(s) may be in the range of GHz. Therefore, the measurement circuitry may comprise frequency divider circuitry configured to divide the oscillation frequency of the ring oscillator circuit arrangement(s) before measurement by the counter circuitry. For example, the control apparatus may be configured to obtain the measurement data from the measurement circuitry via a so-called JTAG interface, named after the Joint Test Action Group, of the semiconductor device.

In addition, or as an alternative to ring oscillators, error counter circuitry of the semiconductor device may be used. Accordingly, the measurement data may comprise measurement data related to an error counter circuitry of the semiconductor device. In this case, the measurement circuitry may comprise the error counter circuitry of the semiconductor device. For example, if the semiconductor device is a memory controller or flash storage controller, error counter circuitry may be included to determine errors being caught via redundancy information stored in the memory or flash storage. An increasing error count may represent the progress of aging of the semiconductor device. For example, the measurement data may comprise measurement data related to an error counter of memory circuitry of the semiconductor device. The same applies to other error counter circuitry as well. For example, the measurement data may comprise measurement data related to a bit error rate of data transmitted by transmitter circuitry or received by receiver circuitry of the semiconductor device. In the former case, the bit error rate may be determined by corresponding receiver circuitry of another semiconductor device and fed back to the semiconductor device.

As is evident, different types of measurement data may be used to determine the device-specific supply voltage. For example, measurement data of ring oscillator circuit arrangement and measurement data of error counter circuitry may be used. In effect, the measurement data may comprise at least two different types of measurement data, e.g., measurement data of ring oscillator circuit arrangement and measurement data of error counter circuitry.

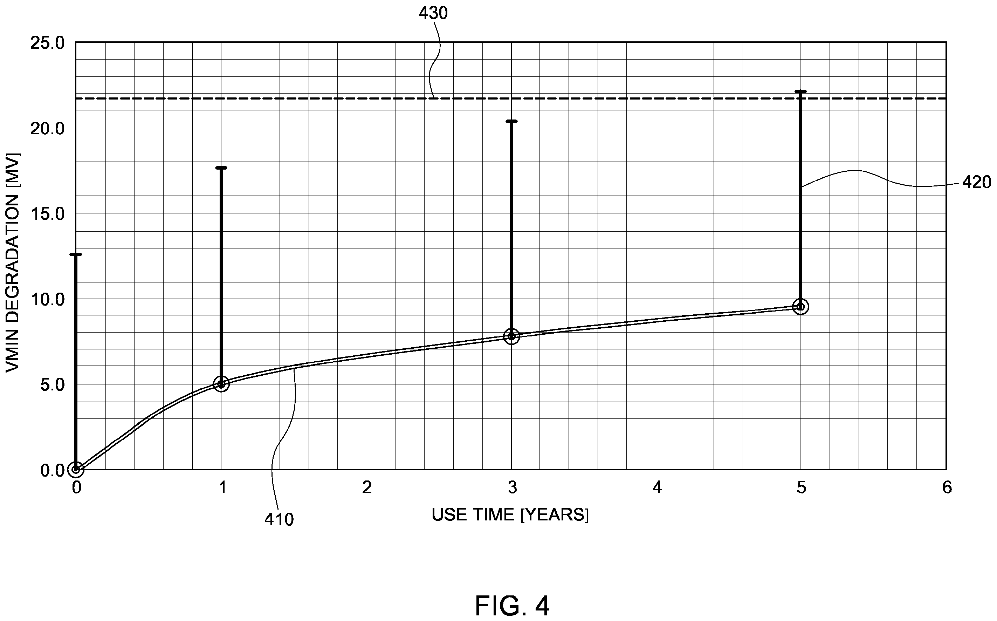

Once the measurement data is determined, it can be used to determine the device-specific supply voltage. In particular, it can be used to determine the guardband voltage (i.e., the voltage being added on top of the nominal supply voltage to compensate for the effects of the progress of aging and to account for standard deviation (see e.g., Fig. 4)). Accordingly, the control apparatus may be configured to determine a guardband voltage of the supply voltage based on the measurement data. Correspondingly, the method may comprise determining 254 a guardband voltage of the supply voltage based on the measurement data.

In general, the control apparatus may be configured to prepare the measurement data for further analysis, e.g., in order to increase the validity and significance of the measurement data. For example, samples of measurement data that have less significance (as they are outliers, or as they are determined in an abnormal state of the semiconductor device) may be removed or discounted from the measurement data. For example, one or more of the following techniques may be applied.

Some semiconductor devices, such as modern CPUs, have a so-called "accelerated state" (also known as "turbo" state), in which the clock frequency of the semiconductor device is increased for a limited amount of time, with the supply voltage of the semiconductor device being increased in line with the increase in clock frequency. In this state, due to the increased supply voltage, the frequency of ring oscillator circuit arrangements is increased as well. Comparisons between measurements taken while in the accelerated state and measurements taken outside the accelerated state may therefore introduce errors in the determination of the device-specific supply voltage. For example, the control apparatus may be configured to take into account the activation of an accelerated state of the semiconductor device in the determination of the device-specific supply voltage of the semiconductor device based on the measurement data. This can be done via different mechanisms - by comparing samples of measurement data generated during the activation of the accelerated state only with other samples of measurement data generated during the activation of the accelerated state, or by discarding the samples of measurement data generated during the activation of the accelerated state. In other words, the control apparatus may be configured to discard measurement data gathered during the activation of an accelerated state of the semiconductor device, or to preempt the semiconductor device from activating the accelerated state while the measurement data is gathered. Accordingly, the method may comprise discarding 212 measurement data gathered

8

during the activation of an accelerated state of the semiconductor device or preempting 214 the semiconductor device from activating the accelerated state while the measurement data is gathered.

Another technique for improving the validity and usefulness of the measurement data is to abstract from the use of single samples of measurement data, e.g., by determining the average or median over multiple samples of measurement data. In other words, the measurement data may comprise a plurality of samples of measurement data. The control apparatus may be configured to determine a median or average of samples, and to determine the device-specific supply voltage based on the median or average of samples. Accordingly, the method may comprise determining 216 a median or average of samples and determining the device-specific supply voltage based on the median or average of samples. The averaging or selecting of the median may be applied at different levels of granularity. For example, averaging or selection of a median may be performed over multiple samples of the same measurement circuit. Alternatively or additionally, averaging or selection of a median may be performed over multiple samples of different measurement circuits (e.g., across samples of different ring oscillator circuit arrangements). As will become evident in the following, in some cases, a difference may be calculated between samples that are based on the first and second ring oscillator circuit arrangement of a pair of ring oscillator circuit arrangements. The averaging or selection of a median may be performed over multiple differences between the samples. All of these techniques can be combined, e.g., such that averages or median values are determined based on other averaged or median values.

As outlined above, the measurement data is related to a progress of aging of the semiconductor device. The control apparatus may thus use the measurement data to determine a measure of aging of the semiconductor device (i.e., a value that represents the progress of aging of the semiconductor device). In other words, the control apparatus may be configured to determine a measure of aging of the semiconductor device based on the measurement data. Accordingly, the method may comprise determining 220 a measure of aging of the semiconductor device based on the measurement data. For example, the measure of aging may correspond to a quantification of the progress of aging of the semiconductor device. The measure of aging may be a (numerical) value representing the progress of aging of the semiconductor device. In general, when using ring oscillator circuit arrangements, the measure of aging may be represented by a frequency or frequency difference (e.g., between a frequency indicated by the measurement data and a frequency measured at burn-in or within an initial set of measurement data taken early in the lifetime of the semiconductor device). When using an error counter, the error rate may be taken as measure of aging. As will become evident in the following, in some examples, the measure of aging may be a more complex value, which is composed of, and/or calculated from, multiple components, with a weighting factor being used to combine the components.

For example, the measurement data may be based on a plurality of different units of measurement circuitry of the semiconductor device (e.g., a plurality of (pairs of) ring oscillator circuit arrangements and/or one or more units of error counter circuitry). Measurement data of these different units of measurement circuitry may be used to determine the device-specific supply voltage, e.g., by determining the measure of aging. Accordingly, the control apparatus may be configured to determine the device-specific supply voltage of the semiconductor device, e.g., the measure of aging, based on a weighing factor (i.e., weighting factor) for weighing (i.e., weighting) a contribution of measurement data of the plurality of different units of measurement circuitry. The weighing factor is a major lever for improving the precision and usefulness of the determination of the device-specific supply voltage and/or the measure of aging. By incorporating measurement data of different units of measurement circuitry, and using an adaptable weighing factor, the advantages of using a flexible software environment for determining the device-specific supply voltage and/or the measure of aging come to light.

In many examples, the weighing factor is not a static weighing factor, but a weighing factor that can be adapted (i.e., that is adaptable) in various ways. For example, the control apparatus may be configured to adapt the weighing factor based on a context in which the measurement data has been determined. Accordingly, the method may comprise adapting 240 the weighing factor based on the context in which the measurement data has been determined. The determination of the context is an advantage over a purely hardware-based approach, as the information required for determining the context might not be readily available at the hardware level. In general, the context may represent the circumstances and/or the environment in which the measurements have been generated. For example, the context in which the measurement data has been determined may be based on an activity factor of circuitry being characterized by the respective units of measurement circuitry. For example, as outlined above, some portion of the circuitry of the semiconductor device may be active for longer periods of time than some other portions. This leads to a so-called activity factor, which may be a ratio between the time the circuitry being characterized by the respective units of measurement circuitry has been activated and the time the semiconductor device has been activated. Another aspect of the context may relate to the time that has passed since burn-in of the semiconductor device and/or the time that has passed since the last update of the device-specific supply voltage. In other words, the context in which the measurement data has been determined may be based on a progress of time over which the aging occurred. For example, the time that has passed since burn-in of the semiconductor device and/or the time that has passed since the last update of the device-specific supply voltage may be used to adapt the weighing factor.

In some examples, the control apparatus may be configured to use the output of a machine-learning model to adapt the weighing factor, with one or more features representing the context being used as input for the machine-learning model. For example, the machine-learning model may take one or more of a feature representing the activity factor, a feature representing the time that has passed since burn-in of the semiconductor device, and a feature representing the time that has passed since the last update of the device-specific supply voltage as input features. The machine-learning model may be trained, e.g., using supervised-learning, to adapt the weighing factor. For example, the machine-learning model may be a pre-trained machine-learning model that is trained based on manually-specified weighing factors as desired output and based on the one or more features representing the context as features of the training input samples.

In various examples, the performance of some circuitry of the semiconductor device may be of greater importance than the performance of other circuitry. In particular, the critical path/speed path may be of heightened importance, as circuitry that is part of the critical path/speed path is critical in achieving the desired/guaranteed performance. This can be reflected in the weighing factor. For example, the control apparatus may be configured to identify one or more performance critical circuits of the semiconductor device (e.g., from a listing of performance critical circuits and/or based on a progress of aging of the one or more performance critical circuits). Accordingly, the method may comprise identifying 230 one or more performance critical circuits of the semiconductor device. The control apparatus may be configured to adapt the weighing factor with respect to measurement circuitry being used to characterize the one or more performance critical circuits. For example, measurement data of measurement circuitry being used to characterize the one or more performance critical circuits may receive a higher weight than measurement circuitry being used to characterize circuitry not deemed to be performance critical. In some extreme cases, the weighing factor may used to focus the determination of the measure of aging and/or of the device-specific supply voltage on a single (or few) performance critical circuit(s), by increasing the weight of the respective measurement data.

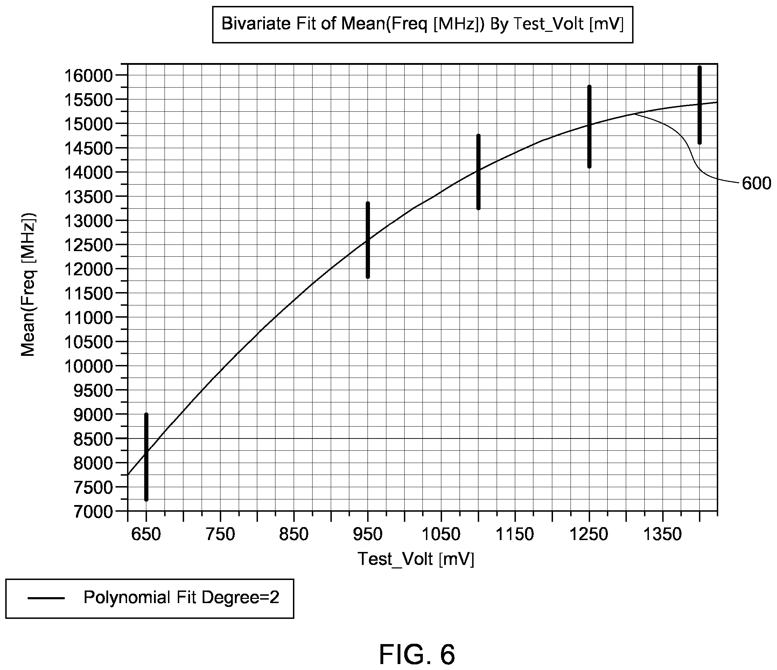

The measure of aging may be used to determine the device-specific supply voltage. In general, two approaches may be used to translate the measure of aging into a corresponding supply voltage - inputting the measure of aging into an equation, or using a look-up table to look up the device-specific supply voltage. In other words, the control apparatus may be configured to determine the device-specific supply voltage based on an equation that takes the measure of aging as input term. Alternatively, the control apparatus may be configured to determine the device-specific supply voltage by looking up the device-specific supply voltage in a look-up-table. The former approach is suitable in scenarios with a linear (or quasi-linear) relationship between the measure of aging and the device-specific supply voltage. The latter approach is suitable in scenarios with a non-linear relationship between the measure of aging and the device-specific supply voltage (see e.g., Fig. 6). In some examples, a hybrid approach may be chosen, with an equation being selected from a data storage, e.g., based on the supply voltage being applied to the semiconductor device during the generation of the measurement data.

In a third approach, the control apparatus may be configured to determine the device-specific supply voltage based on a machine-learning model that takes the measure of aging as input feature. For example, the machine-learning model may be trained to output the device-specific supply voltage for a given input feature representing the measure of aging. For example, the machine-learning model may be pre-trained, e.g., outside the control apparatus, by a manufacturer of the semiconductor device. For example, the machine-learning model may be updated as the manufacturer gains additional experience with respect to the semiconductor device.

The proposed concept is based on tracking the aging process over a long time. Accordingly, the measurement process and determination of the device-specific supply voltage may be repeated in periodic (or aperiodic) intervals over time, to continually adjust the supply voltage to the progress of aging. For example, the control apparatus may be configured to repeatedly update the device-specific supply voltage of the semiconductor device based on the measurement data. In some examples, the control apparatus may be configured to update the device-specific supply voltage according to a pre-defined schedule. Accordingly, the method may comprise updating 260 the device-specific supply voltage according to the pre-defined schedule. For example, a time-scale that is meaningful in the context of semiconductor aging, such as one month may be used as update interval. In other words, the update interval between two subsequent updates of the device-specific supply voltage may be at least one month (or at least two months, or at least three months, or six months). For example, the device-specific supply voltage may be updated yearly or twice-yearly.

In some examples, however, an aperiodic update schedule may be used. For example, semiconductor devices may be "shocked" by suddenly increasing the supply voltage in a large increment (e.g., 0.2 V or 0.3 V at once). If the update interval being used is too long (e.g., after three years), such large increments may be required in order to achieve the desired or guaranteed performance. Therefore, the schedule for updating the device-specific supply voltage may be optimized to find a balance between too many updates (which would expose the reference measurement circuitry to aging) and too few updates (which might lead to changes in the supply voltage that might "shock" the semiconductor device). For example, the control apparatus may be configured to determine a schedule for updating the device-specific supply voltage based on a difference between subsequently determined values of the device-specific supply voltage (or of the measure of aging). Accordingly, the method may comprise determining 262 a schedule for updating the device-specific supply voltage based on a difference between subsequently determined values of the device-specific supply voltage. For example, the schedule of updating the device-specific supply voltage may be determined such, that the difference between subsequently determined values of the device-specific supply voltage (or of the measure of aging) remains under a threshold value.

In some examples, the schedule for updating the device-specific supply voltage using machine-learning. For example, a machine-learning model may be trained, e.g., using supervised learning, with training input samples comprising an input feature related to a time since burn-in (e.g., in days) and a corresponding desired output value related to a device-specific supply voltage at that time. Additionally, each training input sample may comprise one or more additional features, such as an activity factor of the semiconductor device (or a speed path/critical path of the semiconductor device), a supply-voltage applied to the semiconductor device at the time, etc. The machine-learning model may be trained to provide a coarse estimate of the device-specific supply voltage based on the respective input feature or features, which may be used to estimate a time when the estimate reaches the currently-set device-specific supply voltage (or a threshold around the currently-set device-specific supply voltage). Based on the time estimate, the device-specific supply voltage may be updated.

Alternatively or additionally, changes being applied to the device-specific supply voltage may be low-pass filtered, to make sure that the device-specific supply voltage is increased in limited increments. For example, the control apparatus may be to limit a difference between subsequently provided values of the device-specific supply voltage that are provided as part of the information on the device-specific supply voltage to the supply voltage control apparatus (e.g., by limiting the difference to a maximal increment). Accordingly, the method may comprise limiting 264 a difference between subsequently provided values of the device-specific supply voltage that are provided as part of the information on the device-specific supply voltage to the supply voltage control apparatus. If the difference being determined is larger than the maximal increment, the remainder of the difference may be added after a waiting period (e.g., after a month).

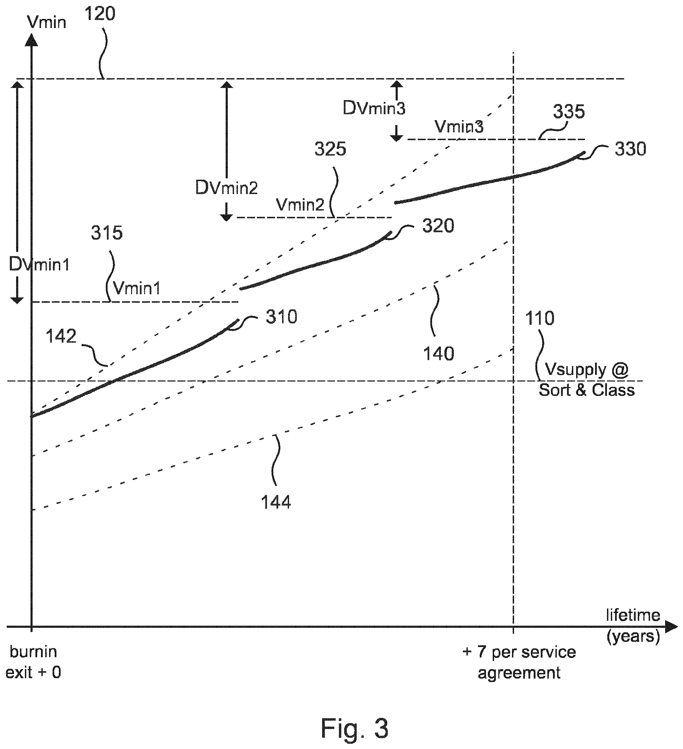

While it may be possible to determine the "ideal" device-specific supply voltage for any given time, in practice, it may also be desirable to reduce the number or frequency of updates to the device-specific supply voltage. Therefore, a ceiling function may be applied to the device-specific supply voltage, or a progress of the measure of aging may be anticipated when determining the device-specific supply voltage. For example, as illustrated in Fig. 3, for example, the device-specific supply voltage (VMin1 315, VMin2 325, VMin3 335) may be chosen such, that the device-specific supply voltage is larger than the "minimal" device-specific supply voltage (graphs 310, 320, 330) for at least a predetermined amount of time (e.g., one year or two years), while remaining lower than the supply voltage 120 that would have been applied in other systems.

Finally, the device-specific supply voltage is provided, as information on the device-specific supply voltage, to the supply voltage control apparatus 205. For example, the control apparatus may be configured to provide the information on the device-specific supply voltage to the supply voltage control apparatus in order to trigger the supply voltage control apparatus to adjust the supply voltage of the semiconductor device to the device-specific supply voltage. Accordingly, the method may comprise providing 270 the information on the device-specific supply voltage to the supply voltage control apparatus in order to trigger the supply voltage control apparatus to adjust the supply voltage of the semiconductor device to the device-specific supply voltage. For example, the information on the device-specific supply voltage may be written into a register that is read by the supply voltage control apparatus, or the control apparatus may be configured to directly control the supply voltage control apparatus, with the information on the device-specific supply voltage being provided as part of a control signal for controlling the supply voltage control apparatus. For example, the updated device-specific supply voltage may be applied at an appropriate time, such as after a shutdown or a warm or cold reboot.

As outlined earlier, in various examples of the present disclosure, the control apparatus, device or method may be implemented using software. Therefore, some examples relate to a machine-readable storage medium including program code, when executed, to cause a machine to perform the method of Fig. 2b. Some examples relate to a computer program having a program code for performing the method of Fig. 2b, when the computer program is executed on a computer, a processor, or a programmable hardware component. Some examples, relate to a machine-readable storage including machine readable instructions, when executed, to implement the method of Fig. 2b or realize the apparatus of Fig. 2a.

For example, the computer program may be executed on a microcontroller that is part of the semiconductor device or that is part of a power controller separate from the semiconductor device (e.g., the supply voltage control apparatus). Alternatively, the computer program may be executed in an operating system being executed using the semiconductor device (e.g., if the semiconductor device is a processor), with the functionality being included in the kernel of the operating system, in a driver or in application software

Various examples are based on using a machine-learning model or machine-learning algorithm. Machine learning refers to algorithms and statistical models that computer systems may use to perform a specific task without using explicit instructions, instead relying on models and inference. For example, in machine-learning, instead of a rule-based transformation of data, a transformation of data may be used, that is inferred from an analysis of historical and/or training data. For example, the content of images may be analyzed using a machine-learning model or using a machine-learning algorithm. In order for the machine-learning model to analyze the content of an image, the machine-learning model may be trained using training images as input and training content information as output. By training the machine-learning model with a large number of training images and associated training content information, the machine-learning model "learns" to recognize the content of the images, so the content of images that are not included of the training images can be recognized using the machine-learning model. The same principle may be used for other kinds of sensor data as well: By training a machine-learning model using training sensor data and a desired output, the machine-learning model "learns" a transformation between the sensor data and the output, which can be used to provide an output based on non-training sensor data provided to the machine-learning model.

Machine-learning models are trained using training input data. The examples specified above use a training method called "supervised learning". In supervised learning, the machine-learning model is trained using a plurality of training samples, wherein each sample may comprise a plurality of input data values (also called "features"), and a plurality of desired output values, i.e. each training sample is associated with a desired output value. By specifying both training samples and desired output values, the machine-learning model "learns" which output value to provide based on an input sample that is similar to the samples provided during the training. Apart from supervised learning, semi-supervised learning may be used. In semi-supervised learning, some of the training samples lack a corresponding desired output value. Supervised learning may be based on a supervised learning algorithm, e.g. a classification algorithm, a regression algorithm or a similarity learning algorithm. Classification algorithms may be used when the outputs are restricted to a limited set of values, i.e. the input is classified to one of the limited set of values. Regression algorithms may be used when the outputs may have any numerical value (within a range). Similarity learning algorithms are similar to both classification and regression algorithms, but are based on learning from examples using a similarity function that measures how similar or related two objects are.

Machine-learning algorithms are usually based on a machine-learning model. In other words, the term "machine-learning algorithm" may denote a set of instructions that may be used to create, train or use a machine-learning model. The term "machine-learning model" may denote a data structure and/or set of rules that represents the learned knowledge, e.g. based on the training performed by the machine-learning algorithm. In examples, the usage of a machine-learning algorithm may imply the usage of an underlying machine-learning model (or of a plurality of underlying machine-learning models). The usage of a machine-learning model may imply that the machine-learning model and/or the data structure/set of rules that is the machine-learning model is trained by a machine-learning algorithm.

For example, the machine-learning model may be an artificial neural network (ANN). ANNs are systems that are inspired by biological neural networks, such as can be found in a brain. ANNs comprise a plurality of interconnected nodes and a plurality of connections, so-called edges, between the nodes. There are usually three types of nodes, input nodes that receiving input values, hidden nodes that are (only) connected to other nodes, and output nodes that provide output values. Each node may represent an artificial neuron. Each edge may transmit information, from one node to another. The output of a node may be defined as a (non-linear) function of the sum of its inputs. The inputs of a node may be used in the function based on a "weight" of the edge or of the node that provides the input. The weight of nodes and/or of edges may be adjusted in the learning process. In other words, the training of an artificial neural network may comprise adjusting the weights of the nodes and/or edges of the artificial neural network, i.e. to achieve a desired output for a given input. In at least some examples, the machine-learning model may be deep neural network, e.g. a neural network comprising one or more layers of hidden nodes (i.e. hidden layers), prefer-ably a plurality of layers of hidden nodes.

Alternatively, the machine-learning model may be a support vector machine. Support vector machines (i.e. support vector networks) are supervised learning models with associated learning algorithms that may be used to analyze data, e.g. in classification or regression analysis. Support vector machines may be trained by providing an input with a plurality of training input values that belong to one of two categories. The support vector machine may be trained to assign a new input value to one of the two categories. Alternatively, the machine-learning model may be a Bayesian network, which is a probabilistic directed acyclic graphical model. A Bayesian network may represent a set of random variables and their conditional dependencies using a directed acyclic graph. Alternatively, the machine-learning model may be based on a genetic algorithm, which is a search algorithm and heuristic technique that mimics the process of natural selection.

The interface circuitry / means for communicating 22 may correspond to one or more inputs and/or outputs for receiving and/or transmitting information, which may be in digital (bit) values according to a specified code, within a module, between modules or between modules of different entities. For example, the interface circuitry / means for communicating 22 may comprise interface circuitry configured to receive and/or transmit information.

In various examples, the processing circuitry / means for processing 24 may be implemented using one or more processing units, one or more processing devices, any means for processing, such as a processor, a computer or a programmable hardware component being operable with accordingly adapted software. In other words, the described function of the processing circuitry / means for processing 24 may as well be implemented in software, which is then executed on one or more programmable hardware components. Such hardware components may comprise a general purpose processor, a Digital Signal Processor (DSP), a micro-controller, etc.

In at least some examples, the storage circuitry / means for storing information 26 may comprise at least one element of the group of a computer readable storage medium, such as a magnetic or optical storage medium, e.g. a hard disk drive, a flash memory, Floppy-Disk, Random Access Memory (RAM), Programmable Read Only Memory (PROM), Erasable Programmable Read Only Memory (EPROM), or an Electronically Erasable Programmable Read Only Memory (EEPROM).

More details and aspects of the control apparatus, control device, method, computer program, semiconductor device and voltage supply control apparatus are mentioned in connection with the proposed concept or one or more examples described above or below (e.g. Fig. 1, 3 to 6). The control apparatus, control device, method, computer program, semiconductor device and voltage supply control apparatus may comprise one or more additional optional features corresponding to one or more aspects of the proposed concept or one or more examples described above or below.

Various examples of the present disclosure relate to a concept that uses an adjustable power-supply voltage.

As outline above, a service agreement of a part may guarantee a certain minimum level of performance over the lifetime of the product. Class binning is usually used to compensate for aging effects to ensure said minimum level near the end of life of the product.

Fig. 3 illustrates the concept of the proposed in-vivo adaptive $V_{min}$ policy. Fig. 3 shows a schematic diagram of a supply voltage required for operating a semiconductor device across its lifetime. Fig. 3 is based on Fig. 1. The x-axis of Fig. 3 shows the time-line, starting from burn-in and manufacturing exit of the semiconductor devices to +7 years. The y-axis shows $V_{min}$. Left of the x-axis. Two supply volage lines are shown in Fig. 3 - a first line 110 denoting $V_{supply}$ at Sort & Class, i.e., the supply voltage that has been used when the parts were sorted into the bin, and a second line 120 denoting $V_{supply}$ that would have been used without the use of the in-vivo adaptive supply voltage. In addition, graphs 140-144 are shown, illustrating the voltages required by the median, weakest, and best parts of the respective bin across the lifetime of the part.

The proposed concept employs an adjustable voltage (e.g., the device-specific supply voltage), which is incrementally increased as necessary to sustain the performance guaranteed by the service agreement. In Fig. 3, the voltage levels are exemplified by Vmin1 315, Vmin2 325, and Vmin3 335. Vmin1 to Vmin3 are, in turn, based on a determination of the device-specific supply voltage 310; 320; 330 over time. As is evident from Fig. 3, Vmin1 315, Vmin2 325, and Vmin3 335 are chosen such, that the respective $V_{min}$ exceeds the determined device-specific supply voltage but remains lower than the $V_{supply}$ 120 used in other systems. The difference between Vmin1 315, Vmin2 325, Vmin3 335 and $V_{supply}$ 120 is indicated as DVmin1, DVmin2 and DVmin3 in Fig. 3. The example use of three different values for Vmin does not imply that the proposed concept is limited in any way to three voltage adjustments.

By operating the part at voltages lower than the state-of-the-art fixed $V_{min}$, the customer using the part stands to benefit threefold.

Most importantly, the lowered power supply voltage may enable savings on the energy bill. Typically, server parts screened using 1.00V of power supply voltage at Sort and Class would be configured to operate at $V_{min}$ = 1.05V. In other words, $V_{min}$ guardband of 50mV is often applied on the product to achieve the guaranteed minimum performance level. Aging and reliability concerns typically accounts for about 10mV of $V_{min}$ degradation plus 12.5mV of standard deviation for a typical product bin, thus accruing as much as 22.5mV of the $V_{min}$ guardband degradation as a function of aging for a typical product. An example of this is shown in Fig. 4. Fig. 4 shows a schematic diagram illustrating a degradation of a minimal supply voltage required for a semiconductor device over time. Graph 410 shows the minimally required supply voltage, bars 420 indicate the standard deviation and line 430 indicates the minimally required guardband.

With the proposed concept, most of this guardband can be recovered. Allowing for some inaccuracies of measurement and estimation employed by the proposed concept, a recovery of 20mV from the initial $V_{min}$ guardband may be considered a reasonable goal. The previous Fig. 3 annotates the performance improvement associated with Vmin1 as DVmin1. This performance improvement leads to corresponding savings in energy.

For example, being able to operate at 1.03V instead of 1.05V in the first year may constitute about 4% of power saving. On a scale in which a customer would spend $4M/yr. on energy bill for a server farm (except for cooling, which is considered separately), the projected saving may amount to $160K in the first year of a brand-new system. On the second year, the projected saving may amount to $120K, the third year, $100K.

Also, less power consumption, and less leakage current may lead to less heating, which saves on cooling bill. On a scale in which a customer would spend $3M/yr. on cooling the server farm, the projected saving may amount to $120K in the first year of a brand-new system. On the second year, the projected saving may amount to $90K, the third year, $75K.

Savings on both operational power and cooling make the part more efficient, providing additional value to the customers utilizing the parts.

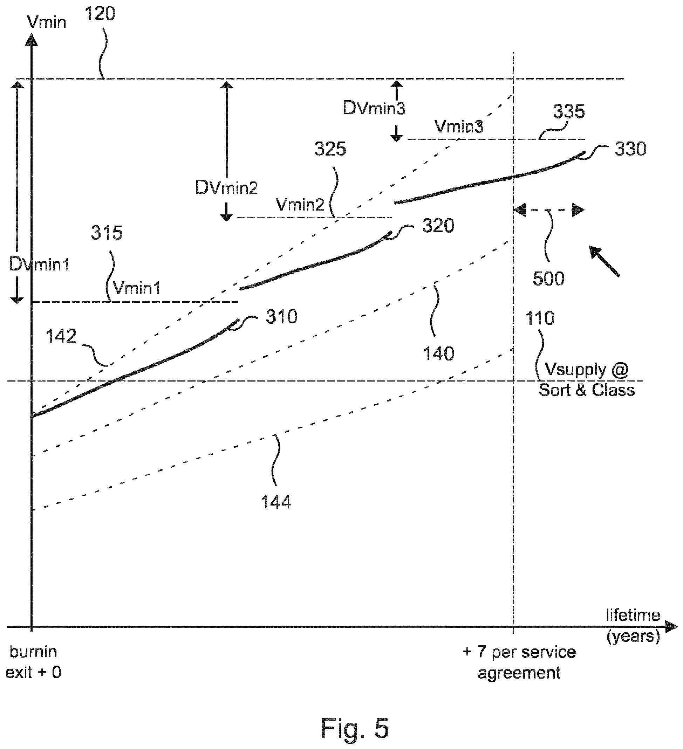

Finally, less degradation due to aging effects at lower voltages may amount to better resilience near the end of life. Fig. 5, which is based on Fig. 3, shows an arrow 500 which indicates the improved lifetime. Fig. 5 shows a schematic diagram of a supply voltage required for operating a semiconductor device across its lifetime, with the lifetime being extended due to reduced supply voltage in the first years. In other words, operating a semiconductor device at a lower power-supply voltage may extend the lifetime of the part.

Design and high-volume manufacturing of the parts by the semiconductor device manufacturer may benefit from the proposed concept. Hardware design requirement can be simplified due to less stringent operating condition.

As described above, in manufacturing, a binning strategy is used to assign each part to be a member of a bin. Each bin supports the sale of a product SKU, which means parts of a given bin must guarantee an agreed-upon minimum performance level. Furthermore, it means that $V_{min}$ is chosen to guarantee said minimum performance by the weakest member of a given bin. In Fig. 1, the space between lines 110 and 120 annotates the guardband component to uphold this guarantee.

By contrast, the proposed concept enables each part to decide its own $V_{min}$, independently of the weakest member of the bin. Being able to configure $V_{min}$ per part in the field, e.g., using a software algorithm, may be considered a key aspect of the proposed concept. The level of sophistication and context-awareness available in software is an advantage compared to state-of-the-art solutions.

Measurement inaccuracies and miscorrelations between IDV measurements and the performance of the critical circuits may subtract from these benefits. However, those inaccuracy may be reduced with reasonable effort by adapting the software being used to implement the concept. Moreover, any additional hardware to implement the proposed concept may be simple and non-intrusive, thus of negligible impact on the development cost.

In the following, a more detailed example is given of the proposed concept.

First, the measurement of aging effects is discussed. As outlined above, In-Die Variation Measurement (IDV) may be used to quantify the aging process of the individual parts. The output from ring-oscillator circuitry being used for IDV is the number of oscillations produced by the IDV within a prescribed interval. The number is proportional to the frequency of oscillation. As the IDV degrades due to aging, its frequency decreases, and so does the measured number. IDV oscillator frequency is usually on the order of a gigahertz, which is too fast to measure using a typically digital counter. It is common practice to apply a frequency divider before counting the number of IDV oscillations.

Aging effects may be measured on an appropriate time scale, as indiscriminately scheduling measurements would not be effective in discerning the overall aging effect. Also, the larger the counting interval, the more accurate the measurement can be. The software stack may also possess information regarding surrounding processor activities (i.e., the "context") which may impact the result of the measurement. This knowledge may guide the schedule for the measurements.

From both structural and behavioral aspects, a high degree of correlation between IDV measurements (i.e., measurement data being related to a progress of aging of the semiconductor device) and the performance of the part may be useful for the application of the proposed concept.

Structurally, there are various choices of IDV oscillators, some correlate with circuitry in the speed paths, others corelate with circuitry in the clock distribution network, etc. A set of carefully selected IDV measurements can be used to determine an overall picture of aging effects across the part. In various examples, pairs of IDV circuitry, designed to measure aging, wherein one is kept fresh as a reference, while the other is activated to serve as an indicator of aging effects, may be used. For example, a power supply for the IDV fublets for measuring aging effects may be isolated, such that they can be activated while other IDV fublets not contributing to the measurement are inactive, thus kept from consuming (any) power.

Behaviorally, to increase or maximize correlation between IDV measurements and the performance of the part, the selected IDV may have the same activity factor and power supply voltage as circuitry of the part critical to the performance.

It is worthwhile to note that, to measure aging effects, the absolute amount of IDV frequency may be considered to be less important than the relative decrease in frequency observed in a series of measurements over years of service.

In many semiconductor device, an existing hardware path (e.g., a JTAG interface, named after the Joint Test Action Group) may be used to make the IDV output accessible to the software thru a secure protocol. For example, the JTAG industry-standard protocol may be used to make IDV information available to the software layer. The hardware paths are multicycle, and thus might not add any synthesis challenge. This path may be made available in vivo. The change in IDV measurement data (e.g., frequency) over years of service may be recorded in a non-volatile memory, with a time-stamp associated with each recording.

In the following, an example of an algorithm to measure aging is discussed. While the previous section focused on the hardware being used to perform the measurements, the next focuses on (software) functionality being used to extract information from the collected measurement data.

At the Operating System's level, there is awareness of the level of activity of the CPU (e.g. turbo mode), of the architectural state of the part and its operating condition, and the passage of time at a large enough scale to be relevant to the aging process. For that reason, the proposed concept specifies that the scheduling of IDV measurements may be performed at the software layer. For example, the software may perform digital signal processing on successive measurements to extract relative degree of aging:

For example, referring to the example of the IDV measurement data relating to an oscillation frequency of a ring oscillator, the software may read the frequency counter value, $F_{REF}$, from the reference IDV oscillator. It may also read the frequency counter value, $F_{CHAR}$, from the IDV oscillator to characterize aging. $F = \| F_{CHAR} - F_{REF} \|$ may be calculated as a measure of aging of the part. The measurement may be repeated a few times to find a stable average value for F.

To reduce or minimize the influence of a confounding variable, it may be useful either to repeat the measurements under different states of that variable, or alternatively to restrict all measurements to be under one specific state of that variable. For example, a part operating in turbo mode has an elevated power supply voltage, which alters its IDV frequency count independently of aging. To reduce or minimize the influence of turbo mode, it is useful either to combine measurements during turbo mode as well as outside of turbo mode, or alternatively to restrict all measurements to be outside of turbo mode.

The measurement results may be stored, with a time-stamp, in a secure, non-volatile memory.

The software may inquire for the world time from the BIOS (Basic Input/Output System) and label each measurement result with the world time to indicate when the measurement is taken. For example, the label may be converted into an integer to indicate the number of days since shipping. Each measurement result is stored as an entry in a key-value table, using the label as the key. The table may be encrypted using the same method for encrypting in-field memory repair. The encrypted information may be stored in a non-volatile (random-access) memory.

In the following, an example is given for the calculation of aging effects. From a given IDV oscillator, a series of frequency measurements and their time-stamps may show the progression of aging effects as a function of time. To illustrate the algorithm, let $F(t0)$ denote the measurement result taken at world time $t_0$, and $F(t_1)$ at $t_1 > t_0$. The quantity $DF$ $(t_1) = F(t_0) - F(t_1)$ represents the change in IDV frequency due to the aging process, and may be translated into a change in $V_{min}$, denoted by $DV_{min}$, to compensate against the measured aging effect. For example, $DF$ may be measure of aging.

In general, $DF$ from a measurement of an IDV degradation might not be translated directly to the corresponding increase of D $V_{min}$ of the entire CPU. The proposed concept does not constrain the translation algorithm. It can be as sophisticated as the situation demands and as the software allows.

In its simplest form, the translation algorithm (equation) may be a linear extrapolation between the two measurements:

$$DVmin\,(t_1) \;=\; V_{min}\,(t_1) - V_{min}\,(t_0) \;=\; G \cdot DF(t_1)$$

wherein $G$ denotes a proportionality factor between the measured frequency degradation versus the amount of power supply voltage adjustment. The value of $G$ may be based on previous analysis of high-volume IDV measurements and may itself be a function of DF.

Another translation approach uses a look-up table, as illustrated in Fig. 6. Fig. 6 shows a schematic diagram of a graph 600 defining a translation between IDV frequency and supply voltage. A relationship between IDV frequency and its power supply voltage is used to calibrate the amount of adaptive response against the measured aging effect. Curve-fitting of $V_{min}$ as a function of time empirically shows affinity to $t^n$, wherein $t$ denotes the amount of time and n is a sensitivity factor that depends on the technology.

Hypothetically, an IDV frequency may degrade on the order of 0.5% after the first 200 hrs. of aging. Assuming a starting IDV frequency of 10 GHz, this amounts to a 50 MHz drop in frequency. Using the table look-up illustrated in Fig. 5, this corresponds to a $DV_{min}$ = 5 mV of increase in the power supply for the particular IDV to compensate for its aging.

In some examples, the translation may be improved by applying a weighing factor on the increase required to compensate for an IDV. Stress duration vs. world time may be accounted for with the help of an acceleration model and statistical understanding based on burn-in. This weighing factor may depend on the extent that the particular IDV represents the most vulnerable constituent of the part. In the case of multiple limiting constituents, each represented by a different IDV measurement, their DF may be weighed appropriately to form a composite DF representative of aging of the part in its entirety.

As an example, a design-of-experiment (DOE) performance analysis of an IDV matched with a particular speed path reveals a $DV_{min}$ = 5 mV if its activity factor is 100%. But if the actual activity factor of the circuitry involved in the speed path is only 50%, then said $DV_{min}$ = 5 mV may be de-rated appropriately. Also, in case there are multiple factors impacting the performance of a part, $DV_{min}$ associated with the most dominant factor may become associated with the entire part.

All of the proposed aspects of the translation method can be easily implemented in software but are quite impractical to be implemented in hardware. Therein is an important advantage and novelty of the proposed concept, which may employ software to perform the translation.

In the following, an adaptation of the semiconductor device against aging effects is described. Lowering the voltage on the power supply to CPU may reduce effects of its irreversible aging progression. It is widely accepted as the most promising technique to manage aging.

After the computation described above, a new value of $V_{min}$ is recommended to the power-management unit (e.g., the supply voltage control apparatus or device). Care may be exercised to recommend only a small amount of change with respect to the present $V_{min}$. This is another advantage of using software to schedule the measurements and ultimately the adjustments. Too much time between consecutive adjustments may be liable to cause a large change in $V_{min}$; too little would cause un-necessary expenditure of resources to measure DF and calculate a new recommendation for $V_{min}$. To avoid any adverse effect on the functionality of the part due to an adjustment in the power supply voltage, the power-management unit may make the adjustment during the next available Warm Reset or an otherwise equally idle architectural state.

In summary, the proposed mechanism (e.g., the software) may schedule the IDV frequency measurements, and extract aging information from these measurements. Based on that information, the proposed mechanism (e.g., the software) may make a recommendation of the power supply voltage necessary to uphold the service agreement regarding the guaranteed performance per part in the field.

As used herein the term "and/or" includes any and all combinations of one or more of the associated listed items and may be abbreviated as "/".

Although some aspects have been described in the context of an apparatus, it is clear that these aspects also represent a description of the corresponding method, where a block or device corresponds to a method step or a feature of a method step. Analogously, aspects described in the context of a method step also represent a description of a corresponding block or item or feature of a corresponding apparatus.

As used herein, the term "module" refers to logic that may be implemented in a hardware component or device, software or firmware running on a processing unit, or a combination thereof, to perform one or more operations consistent with the present disclosure. Software and firmware may be embodied as instructions and/or data stored on non-transitory computer-readable storage media. As used herein, the term "circuitry" can comprise, singly or in any combination, non-programmable (hardwired) circuitry, programmable circuitry such as processing units, state machine circuitry, and/or firmware that stores instructions executable by programmable circuitry. Modules described herein may, collectively or individually, be embodied as circuitry that forms a part of a computing system. Thus, any of the modules can be implemented as circuitry. A computing system referred to as being programmed to perform a method can be programmed to perform the method via software, hardware, firmware, or combinations thereof.

Any of the disclosed methods (or a portion thereof) can be implemented as computer-executable instructions or a computer program product. Such instructions can cause a computing system or one or more processing units capable of executing computer-executable instructions to perform any of the disclosed methods. As used herein, the term "computer" refers to any computing system or device described or mentioned herein. Thus, the term "computer-executable instruction" refers to instructions that can be executed by any computing system or device described or mentioned herein.

Examples may further be or relate to a (computer) program including a program code to execute one or more of the above methods when the program is executed on a computer, processor, or other programmable hardware component. Thus, steps, operations, or processes of different ones of the methods described above may also be executed by programmed computers, processors, or other programmable hardware components. Examples may also cover program storage devices, such as digital data storage media, which are machine-, processor- or computer-readable and encode and/or contain machine-executable, processor-executable or computer-executable programs and instructions. Program storage devices may include or be digital storage devices, magnetic storage media such as magnetic disks and magnetic tapes, hard disk drives, or optically readable digital data storage media, for example. Other examples may also include computers, processors, control units, (field) programmable logic arrays ((F)PLAs), (field) programmable gate arrays ((F)PGAs), graphics processor units (GPU), application-specific integrated circuits (ASICs), integrated circuits (ICs) or system-on-a-chip (SoCs) systems programmed to execute the steps of the methods described above.

The computer-executable instructions can be part of, for example, an operating system of the computing system, an application stored locally to the computing system, or a remote application accessible to the computing system (e.g., via a web browser). Any of the methods described herein can be performed by computer-executable instructions performed by a single computing system or by one or more networked computing systems operating in a network environment. Computer-executable instructions and updates to the computer-executable instructions can be downloaded to a computing system from a remote server.

Further, it is to be understood that implementation of the disclosed technologies is not limited to any specific computer language or program. For instance, the disclosed technologies can be implemented by software written in C++, C#, Java, Perl, Python, JavaScript, Adobe Flash, C#, assembly language, or any other programming language. Likewise, the disclosed technologies are not limited to any particular computer system or type of hardware.

Furthermore, any of the software-based embodiments (comprising, for example, computer-executable instructions for causing a computer to perform any of the disclosed methods) can be uploaded, downloaded, or remotely accessed through a suitable communication means. Such suitable communication means include, for example, the Internet, the World Wide Web, an intranet, cable (including fiber optic cable), magnetic communications, electromagnetic communications (including RF, microwave, ultrasonic, and infrared communications), electronic communications, or other such communication means.

It is further understood that the disclosure of several steps, processes, operations, or functions disclosed in the description or claims shall not be construed to imply that these operations are necessarily dependent on the order described, unless explicitly stated in the individual case or necessary for technical reasons. Therefore, the previous description does not limit the execution of several steps or functions to a certain order. Furthermore, in further examples, a single step, function, process, or operation may include and/or be broken up into several sub-steps, -functions, -processes or -operations.

If some aspects have been described in relation to a device or system, these aspects should also be understood as a description of the corresponding method. For example, a block, device or functional aspect of the device or system may correspond to a feature, such as a method step, of the corresponding method. Accordingly, aspects described in relation to a method shall also be understood as a description of a corresponding block, a corresponding element, a property or a functional feature of a corresponding device or a corresponding system.

The disclosed methods, apparatuses, and systems are not to be construed as limiting in any way. Instead, the present disclosure is directed toward all novel and nonobvious features and aspects of the various disclosed embodiments, alone and in various combinations and subcombinations with one another. The disclosed methods, apparatuses, and systems are not limited to any specific aspect or feature or combination thereof, nor do the disclosed embodiments require that any one or more specific advantages be present or problems be solved.

Theories of operation, scientific principles, or other theoretical descriptions presented herein in reference to the apparatuses or methods of this disclosure have been provided for the purposes of better understanding and are not intended to be limiting in scope.

## Claims

1.  A control device (20) for determining a device-specific supply voltage for a semiconductor device (200), the control device comprising means for processing (24) and means for storing information (26), wherein the control device is configured to:

    Obtain measurement data of measurement circuitry of the semiconductor device, the measurement data being related to a progress of aging of the semiconductor device;
    Determine the device-specific supply voltage of the semiconductor device based on the measurement data; and
    Provide information on the device-specific supply voltage for a supply voltage control device (205),
    **characterised in that** the control device is configured to repeatedly update the device-specific supply voltage of the semiconductor device based on the measurement data, and to determine a schedule for updating the device-specific supply voltage based on a difference between subsequently determined values of the device-specific supply voltage.

2.  The control device according to claim 1, wherein the device-specific supply voltage is based on the progress of aging of the semiconductor device, with the progress of aging being based on an individual aging process of the semiconductor device in the field.

3.  The control device according to one of the claims 1 or 2, wherein the control device is configured to increase the device-specific supply voltage as the aging of the semiconductor device progresses.

4.  The control device according to one of the claims 1 to 3, wherein the progress of aging of the semiconductor device is based on a utilization of the semiconductor device, with the measurement data reflecting the utilization of the semiconductor device.

5.  The control device according to one of the claims 1 to 4, wherein the device-specific supply voltage is specific to the semiconductor device comprising the measurement circuitry.

6.  The control device according to one of the claims 1 to 5, wherein the control device is configured to update the device-specific supply voltage according to a pre-defined schedule.

7.  The control device according to one of the claims 1 to 6, wherein the measurement data comprises measurement data related to one or more ring oscillator circuit arrangements of the semiconductor device.

8.  The control device according to claim 7, wherein the measurement data related to one or more ring oscillator circuit arrangements corresponds to measurement data related to one or more pairs of ring oscillator circuit arrangements, with each pair of ring oscillator circuit arrangements comprising a first ring oscillator circuit arrangement having a performance being dependent on the progress of aging of the semiconductor device, and a second oscillator circuitry being at least partially safeguarded from the progress of aging of the semiconductor device.

9.  The control device according to one of the claims 1 to 8, wherein the control device is configured to discard measurement data gathered during the activation of an accelerated state of the semiconductor device, or to preempt the semiconductor device from activating the accelerated state while the measurement data is gathered.

10. The control device according to one of the claims 1 to 9, wherein the measurement data is based on a plurality of different units of measurement circuitry of the semiconductor device, wherein the control device is configured to determine the device-specific supply voltage of the semiconductor device based on a weighing factor for weighing a contribution of measurement data of the plurality of different units of measurement circuitry.

11. The control device according to one of the claims 1 to 10, wherein the measurement data comprises a plurality of samples of measurement data, wherein the control device is configured to determine a median or average of samples, and to determine the device-specific supply voltage based on the median or average of samples.

12. A semiconductor device comprising the control device according to one of the claims 1 to 11, wherein the control device is implemented by software being executed on a microcontroller of the semiconductor device.

13. A method for determining a device-specific supply voltage for a semiconductor device (200), the method comprising:

Obtaining (210) measurement data of measurement circuitry of the semiconductor device, the measurement data being related to a progress of aging of the semiconductor device;
Determining (250) the device-specific supply voltage of the semiconductor device based on the measurement data; and
Providing (270) information on the device-specific supply voltage for a supply voltage control device (205),
**characterised in that**
the method comprises repeatedly updating the device-specific supply voltage of the semiconductor device based on the measurement data, and determining a schedule for updating the device-specific supply voltage based on a difference between subsequently determined values of the device-specific supply voltage.

14. A computer program having a program code for performing the method of claim 13, when the computer program is executed on a computer, a processor, or a programmable hardware component.

**Patentansprüche**

1. Steuervorrichtung (20) zur Ermittlung einer gerätespezifischen Versorgungsspannung für ein Halbleiterbauelement (200), wobei die Steuervorrichtung Verarbeitungsmittel (24) und Speichermittel (26) umfasst, wobei die Steuervorrichtung dazu konfiguriert ist:

Messdaten einer Messschaltung des Halbleiterbauelements zu erhalten, wobei die Messdaten mit dem Fortschritt der Alterung des Halbleiterbauelements in Zusammenhang stehen;
die gerätespezifische Versorgungsspannung des Halbleiterbauelements basierend auf den Messdaten zu ermitteln; und
Informationen über die gerätespezifische Versorgungsspannung an eine Versorgungsspannungs-Steuervorrichtung (205) bereitzustellen,
**dadurch gekennzeichnet, dass** die Steuervorrichtung dazu konfiguriert ist, die gerätespezifische Versorgungsspannung des Halbleiterbauelements wiederholt auf Basis der Messdaten zu aktualisieren, und einen Aktualisierungsplan für die gerätespezifische Versorgungsspannung zu ermitteln, basierend auf einem Unterschied zwischen jeweils nacheinander bestimmten Werten der gerätespezifischen Versorgungsspannung.

2. Steuervorrichtung nach Anspruch 1, wobei die gerätespezifische Versorgungsspannung auf dem Fortschritt der Alterung des Halbleiterbauelements basiert, wobei der Fortschritt der Alterung auf einem individuellen Alterungsprozess des Halbleiterbauelements im Feldbetrieb beruht.

3. Steuervorrichtung nach einem der Ansprüche 1 oder 2, wobei die Steuervorrichtung dazu konfiguriert ist, die gerätespezifische Versorgungsspannung zu erhöhen, wenn der Alterungsfortschritt des Halbleiterbauelements zunimmt.

4. Steuervorrichtung nach einem der Ansprüche 1 bis 3, wobei der Fortschritt der Alterung des Halbleiterbauelements auf einer Nutzung des Halbleiterbauelements basiert, wobei die Messdaten die Nutzung des Halbleiterbauelements widerspiegeln.

5. Steuervorrichtung nach einem der Ansprüche 1 bis 4, wobei die gerätespezifische Versorgungsspannung spezifisch für das Halbleiterbauelement ist, das die Messschaltung umfasst.

6. Steuervorrichtung nach einem der Ansprüche 1 bis 5, wobei die Steuervorrichtung dazu konfiguriert ist, die gerätespezifische Versorgungsspannung gemäß einem vordefinierten Zeitplan zu aktualisieren.

7. Steuervorrichtung nach einem der Ansprüche 1 bis 6, wobei die Messdaten Messdaten umfassen, die sich auf eine oder mehrere Ringoszillatorschaltungen des Halbleiterbauelements beziehen.

8. Steuervorrichtung nach Anspruch 7, wobei sich die Messdaten, die sich auf eine oder mehrere Ringoszillatorschaltungen beziehen, auf Messdaten beziehen, die sich auf ein oder mehrere Paare von Ringoszillatorschaltungen beziehen, wobei jedes Paar von Ringoszillatorschaltungen eine erste Ringoszillatorschaltung umfasst, deren Leistung vom Fortschritt der Alterung des Halbleiterbauelements abhängig ist, und eine zweite Oszillatorschaltung, die wenigstens teilweise gegen den Fortschritt der Alterung des Halbleiterbauelements abgeschirmt ist.

9. Steuervorrichtung nach einem der Ansprüche 1 bis 8, wobei die Steuervorrichtung dazu konfiguriert ist, Messdaten, die während der Aktivierung eines beschleunigten Zustands des Halbleiterbauelements erfasst wurden, zu verwerfen, oder die Aktivierung des beschleunigten Zustands durch das Halbleiterbauelement während der Erfassung der Messdaten zu verhindern.

10. Steuervorrichtung nach einem der Ansprüche 1 bis 9, wobei die Messdaten auf einer Vielzahl unterschiedlicher Messeinheiten der Messschaltung des Halbleiterbauelements basieren, wobei die Steuervorrichtung dazu konfiguriert ist, die gerätespezifische Versorgungsspannung des Halbleiterbauelements unter Verwendung eines Gewichtungsfaktors zu ermitteln, um den Beitrag der Messdaten der unterschiedlichen Messeinheiten der Messschaltung zu gewichten.

11. Steuervorrichtung nach einem der Ansprüche 1 bis 10, wobei die Messdaten eine Vielzahl von Messwertproben umfassen, wobei die Steuervorrichtung dazu konfiguriert ist, einen Median oder Mittelwert der Messwertproben zu ermitteln und die gerätespezifische Versorgungsspannung basierend auf dem Median oder Mittelwert der Messwertproben zu ermitteln.

12. Halbleiterbauelement, umfassend eine Steuervorrichtung nach einem der Ansprüche 1 bis 11, wobei die Steuervorrichtung durch Software implementiert ist, die auf einem Mikrocontroller des Halbleiterbauelements ausgeführt wird.

13. Verfahren zur Bestimmung einer gerätespezifischen Versorgungsspannung für ein Halbleiterbauelement (200), das Verfahren umfassend:

Erhalten (210) von Messdaten einer Messschaltung des Halbleiterbauelements, wobei die Messdaten mit einem Fortschritt der Alterung des Halbleiterbauelements in Zusammenhang stehen;
Ermitteln (250) der gerätespezifischen Versorgungsspannung des Halbleiterbauelements basierend auf den Messdaten; und
Bereitstellen (270) von Informationen über die gerätespezifische Versorgungsspannung für eine Versorgungsspannungs-Steuervorrichtung (205),
**dadurch gekennzeichnet, dass** das Verfahren umfasst, die gerätespezifische Versorgungsspannung des Halbleiterbauelements wiederholt auf Basis der Messdaten zu aktualisieren, und einen Aktualisierungsplan für die gerätespezifische Versorgungsspannung zu ermitteln, basierend auf einem Unterschied zwischen jeweils nacheinander bestimmten Werten der gerätespezifischen Versorgungsspannung.

14. Computerprogramm, das einen Programmcode zum Durchführen des Verfahrens nach Anspruch 13, wenn das Computerprogramm auf einem Prozessor oder einer programmierbaren Hardwarekomponente ausgeführt wird, aufweist.

**Revendications**

1. Dispositif de commande (20) pour déterminer une tension d'alimentation spécifique à un dispositif pour un dispositif à semi-conducteur (200), le dispositif de commande comprenant des moyens de traitement (24) et des moyens de stockage d'informations (26), le dispositif de commande étant configuré pour :

obtenir des données de mesure d'un circuit de mesure du dispositif à semi-conducteur, les données de mesure étant liées à une progression du vieillissement du dispositif à semi-conducteur ;

déterminer la tension d'alimentation spécifique à un dispositif du dispositif à semi-conducteur sur la base des données de mesure ; et

fournir des informations sur la tension d'alimentation spécifique à un dispositif pour un dispositif de commande de tension d'alimentation (205),

**caractérisé en ce que** le dispositif de commande est configuré pour mettre à jour de manière répétée la tension d'alimentation spécifique à un dispositif du dispositif à semi-conducteur sur la base des données de mesure, et pour déterminer un programme pour la mise à jour de la tension d'alimentation spécifique à un dispositif sur la base d'une différence entre des valeurs déterminées ultérieurement de la tension d'alimentation spécifique à un dispositif.

2. Dispositif de commande selon la revendication 1, la tension d'alimentation spécifique à un dispositif étant basée sur la progression du vieillissement du dispositif à semi-conducteur, la progression du vieillissement étant basée sur un processus de vieillissement individuel du dispositif à semi-conducteur sur le terrain.

3. Dispositif de commande selon l'une des revendications 1 ou 2, le dispositif de commande étant configuré pour augmenter la tension d'alimentation spécifique à un dispositif à mesure que le vieillissement du dispositif à semi-conducteur progresse.

4. Dispositif de commande selon l'une des revendications 1 à 3, la progression du vieillissement du dispositif à semi-conducteur étant basée sur une utilisation du dispositif à semi-conducteur, les données de mesure reflétant l'utilisation du dispositif à semi-conducteur.

5. Dispositif de commande selon l'une des revendications 1 à 4, la tension d'alimentation spécifique à un dispositif étant spécifique au dispositif à semi-conducteur comprenant le circuit de mesure.

6. Dispositif de commande selon l'une des revendications 1 à 5, le dispositif de commande étant configuré pour mettre à jour la tension d'alimentation spécifique à un dispositif selon un programme prédéfini.

7. Dispositif de commande selon l'une des revendications 1 à 6, les données de mesure comprenant des données de mesure relatives à un ou plusieurs agencements de circuits oscillateurs en anneau du dispositif à semi-conducteur.

8. Dispositif de commande selon la revendication 7, les données de mesure relatives à un ou plusieurs agencements de circuits oscillateurs en anneau correspondant à des données de mesure relatives à une ou plusieurs paires d'agencements de circuits oscillateurs en anneau, chaque paire d'agencements de circuits oscillateurs en anneau comprenant un premier agencement de circuits oscillateurs en anneau dont les performances dépendent de la progression du vieillissement du dispositif à semi-conducteur, et un second circuit oscillateur au moins partiellement protégé contre la progression du vieillissement du dispositif à semi-conducteur.

9. Dispositif de commande selon l'une des revendications 1 à 8, le dispositif de commande étant configuré pour rejeter les données de mesure recueillies pendant l'activation d'un état accéléré du dispositif à semi-conducteur, ou pour empêcher le dispositif à semi-conducteur d'activer l'état accéléré pendant que les données de mesure sont recueillies.

10. Dispositif de commande selon l'une des revendications 1 à 9, les données de mesure étant basées sur une pluralité d'unités différentes de circuits de mesure du dispositif à semi-conducteur, le dispositif de commande étant configuré pour déterminer la tension d'alimentation spécifique à un dispositif du dispositif à semi-conducteur sur la base d'un facteur de pondération pour pondérer une contribution des données de mesure de la pluralité d'unités différentes de circuits de mesure.

11. Dispositif de commande selon l'une des revendications 1 à 10, les données de mesure comprenant une pluralité d'échantillons de données de mesure, le dispositif de commande étant configuré pour déterminer une médiane ou une moyenne des échantillons, et pour déterminer la tension d'alimentation spécifique à un dispositif sur la base de la médiane ou de la moyenne des échantillons.

12. Dispositif à semi-conducteur comprenant le dispositif de commande selon l'une des revendications 1 à 11, le dispositif de commande étant mis en œuvre par un logiciel en cours d'exécution sur un microcontrôleur du dispositif à semi-conducteur.

13. Procédé pour déterminer une tension d'alimentation spécifique à un dispositif pour un dispositif à semi-conducteur (200), le procédé comprenant :

l'obtention (210) de données de mesure d'un circuit de mesure du dispositif à semi-conducteur, les données de mesure étant liées à une progression du vieillissement du dispositif à semi-conducteur ;
la détermination (250) de la tension d'alimentation spécifique à un dispositif du dispositif à semi-conducteur sur la base des données de mesure ; et
la fourniture (270) d'informations sur la tension d'alimentation spécifique à un dispositif pour un dispositif de commande de tension d'alimentation (205),
**caractérisé en ce que** le procédé comprend la mise à jour répétée de la tension d'alimentation spécifique à un dispositif du dispositif à semi-conducteur sur la base des données de mesure, et la détermination d'un programme pour la mise à jour de la tension d'alimentation spécifique à un dispositif sur la base d'une différence entre des valeurs déterminées ultérieurement de la tension d'alimentation spécifique à un dispositif.

14. Programme informatique ayant un code de programme pour réaliser le procédé selon la revendication 13, lorsque le programme informatique est en cours d'exécution sur un ordinateur, un processeur ou un composant matériel programmable.

Fig. 1

SUPPLY
VOLTAGE
CONTROL
205

INTERFACE
CIRCUITRY — 22

PROCESSING
CIRCUITRY — 24

STORAGE
CIRCUITRY — 26

20

Fig. 2a

SEMICONDUCTOR DEVICE

SUPPLY
VOLTAGE
CONTROL
205

INTERFACE
CIRCUITRY — 22

PROCESSING
CIRCUITRY — 24

STORAGE
CIRCUITRY — 26

200          20

SOFTWARE

CONTEXT-
AWARE
SCHEDULING

PROCESSING

SECURE
RECORDING/
STORAGE

Fig. 2c

SEMICONDUCTOR
DEVICE

SUPPLY
VOLTAGE
CONTROL
205

INTERFACE
CIRCUITRY — 22

PROCESSING
CIRCUITRY — 24

STORAGE
CIRCUITRY — 26

200          20

SOFTWARE

CONTEXT-
AWARE
SCHEDULING

PROCESSING

SECURE
RECORDING/
STORAGE

Fig. 2d

OBTAINING MEASUREMENT DATA — 210

DISCARDING MEASUREMENT DATA — 212

PREEMPTING ACTIVATION OF
ACCELERATED STATE — 214

DETERMINING AN AVERAGE OR MEDIAN — 216

DETERMINING A MEASURE OF AGING — 220

IDENTIFYING PERFORMANCE-
CRITICAL CIRCUITS — 230

ADAPTING A WEIGHING FACTOR — 240

DETERMINING A DEVICE-SPECIFIC
SUPPLY VOLTAGE — 250

INCREASING THE DEVICE-SPECIFIC
SUPPLY VOLTAGE — 252

DETERMINING A GUARDBAND VOLTAGE — 254

LOOKING UP THE DEVICE-SPECIFIC
SUPPLY VOLTAGE — 256

UPDATING THE DEVICE-SPECIFIC
SUPPLY VOLTAGE — 260

DETERMINING A SCHEDULE
FOR UPDATING — 262

LIMITING A DIFFERENCE — 264

PROVIDING INFORMATION ON THE
DEVICE-SPECIFIC SUPPLY VOLTAGE
TO SUPPLY VOLTAGE CONTROL UNIT — 270

## Fig. 2b

Fig. 3

FIG. 4

EP 4 155 741 B1

Fig. 5

Bivariate Fit of Mean(Freq [MHz]) By Test_Volt [mV]

— Polynomial Fit Degree=2

FIG. 6

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 9672310 B1

- US 2014312873 A